# EUROPEAN PATENT APPLICATION

(11) **EP 3 096 455 A1**
(43) Date of publication of application: **23.11.2016**
(21) Application number: 16174333.1
(22) Date of filing: 23.02.2001
(51) Int. Cl.: H03K 17/0412, H03K 17/567, H03K 17/687

(54) **DRIVE CIRCUIT AND METHOD FOR MOSFET**

(30) Priority: 23.02.2000 ZA 200000887
(62) Divisional of application: 01918992.7
(71) Applicant: North-West University, Potchefstroom 2351 (ZA)
(72) Inventor: Barend, VISSER, 2531 Potchefstroom (ZA)
(74) Representative: Jackson, Derek Charles

(57) **Abstract**

A circuit and a method of using a circuit to drive an insulated gate semiconductor device (12) comprising as a first terminal a gate (20) and at least second and third terminals (22, 24). The circuit comprises a charge storage device (14) and switching means (16, 116) connected in a series circuit to the gate of the semiconductor device to transfer charge from the charge storage device to the gate of the semiconductor device so as to switch the semiconductor device between one of an on state and an off state and the other of the on state and the off state. Sufficient charge to switch the device on is transferred from the charge storage device to the gate during a charge transfer stage which is complete prior to a change in the current flow between the second and third terminals (22, 24) of the semiconductor device and during which a voltage on the gate exceeds and then remains above a threshold voltage between the gate and the third terminal of the device.

## Description

### Technical Field

This invention relates to a circuit and method for improving the switching speed of insulated gate semiconductor devices such as metal oxide field effect transistors (MOSFET's), more particularly power MOSFET's.

### Background Art

Capacitance inherent in transistor junctions limits the speed at which a voltage within a circuit can switch. It is also well known that the Miller effect has an influence on the capacitance at the gate of devices of the aforementioned kind.

Prior art teaches a number of methods of alleviating the Miller effect in high frequency transistor switching circuits, for example by reducing source impedance or reducing feedback capacitance, or both.

Even with such improvements, an output of a MOSFET such as an IRF740 typically switches through 200 volts in a rise time of approximately 27ns at a peak current of 10 amperes and in a fall time of approximately 24ns.

These times may be too long for many applications.

### Object of the invention

Accordingly, it is an object of the present invention to provide a triggering circuit and method for improving the rise and/or fall times of insulated gate semiconductor devices with which the applicant believes the aforementioned disadvantages will at least be alleviated.

### Summary of the invention

According to the invention there is provided a triggering circuit for an insulated gate semiconductor device comprising as a first terminal a gate and further comprising at least a second and a third terminal, the circuit comprising:
- a charge storage device and a fast switching means connected in a circuit to the gate of the device;
- the fast switching means being able to switch between an off and an on state in a first time period shorter than a specified turn-on delay time of the insulated gate device; and
- the fast switching means being controllable to move charge between the storage device and the gate of the insulated gate device, so that the insulated gate device switches between an off state and an on state in a second time period shorter than a specified rise time or fall time for the insulated gate device.

The insulated gate semiconductor device may be a metal oxide semiconductor field effect transistor (MOSFET), such as a power MOSFET.

Alternatively, the insulated gate semiconductor device may be an insulated gate bipolar transistor.

The first time period is preferably shorter than 2ns.

The fast switching means may comprise one of: a SIDAC, a break-over diode, a bipolar transistor, another insulated gate semiconductor device and a high voltage fast switching device.

The specified turn-on time is typically a minimum turn-on time specified in a publicly available data sheet relating to the insulated gate semiconductor device.

The fast switching means may be electronically controllable.

The charge storage device may be a capacitor.

The insulated gate semiconductor device may switch from the off state to the on state as well as from the on state to the off state in periods shorter than specified rise and fall times respectively.

An inductor may be provided in the circuit between the fast switching means and the gate.

The triggering circuit may be integrated on a single chip.

The chip may further comprise additional circuitry also integrated thereon.

According to another aspect of the invention, a method of driving an insulated gate semiconductor device comprises the steps of:
- utilizing a fast switching means to transfer charge to a gate of the device;
- switching the fast switching means on in a first time period shorter than a specified turn-on delay time of the insulated gate device;
- moving charge to and from the gate to cause the insulated gate device to switch between an off and an on state in a second time period shorter than a specified rise time or fall time for the insulated gate device.

### Brief description of the drawings

The invention will now be described, by way of example only, with reference to the accompanying drawings wherein:
figure 1 is a basic circuit diagram of a triggering circuit according to the invention for a MOSFET;
figure 2 is a diagram of one embodiment of the circuit comprising a SIDAC as fast switching device;
figure 3 includes a diagram in dotted lines of gate voltage against time of normal specified operation of the MOSFET and a diagram in solid lines of operation according to the method of the invention;
figure 4 includes a diagram in dotted lines of gate current against time of normal specified operation of the MOSFET and a diagram in solid lines of operation according to the method of the invention;
figure 5 is a diagram of another embodiment of the circuit according to the invention;
figure 6 is a waveform of voltage against time at a first terminal of a charge storage capacitor in figure 5;
figure 7 is a waveform of voltage against time at the source of the MOSFET in figure 5;
figure 8 is a diagram of a triggering circuit for an insulated gate bipolar transistor;
figure 9 is a waveform of voltage against time at a first terminal of a charge storage capacitor in the circuit in figure 8;
figure 10 is a waveform of voltage against time at an emitter of the transistor in figure 8; and
figure 11 is a basic circuit diagram of yet another embodiment of the triggering circuit.

### Description of a preferred embodiment of the invention

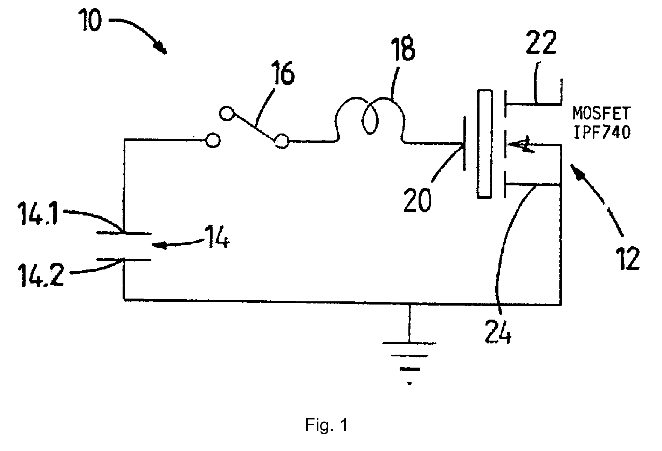

In figure 1, there is shown a basic diagram of a triggering circuit 10 according to the invention for an insulated gate semiconductor device 12 such as a metal oxide semiconductor field effect transistor (MOSFET).

In the diagram a power MOSFET is shown and which is available from

International Rectifier under the trademark HEXFET number IRF740. A 10% to 90% rise time of an output voltage is specified in publicly available user data sheets of the device as being about 27ns and a corresponding fall time is specified as being in the order of 24ns. These times may be too long for some applications of the MOSFET. The turn-on delay time is specified at 14ns and the turn-off delay time as 50ns.

The triggering circuit 10 comprises a charge storage device in the form of a capacitor 14 having first and second terminals 14.1 and 14.2 respectively. The first terminal 14.1 is connected in a circuit 17 to a fast switching device 16. An optional inductor 18 is connected between the fast switching device 16 and a gate 20 of the MOSFET. The drain and source of the MOSFET are shown at 22 and 24 respectively.

The fast switching device 16 may be any suitable device having a switching speed faster than the data sheet specified turn-on delay time and/or turn-off delay time of the MOSFET, preferably better than 2ns. Such devices may include a SIDAC, a break-over diode, a suitably configured bipolar transistor arrangement, or any other suitable fast switching device or circuit.

To switch the MOSFET on, the fast switching device is switched on electronically which rapidly transfers sufficient charge from the capacitor 14 to the gate 20 of the MOSFET, to switch the MOSFET on.

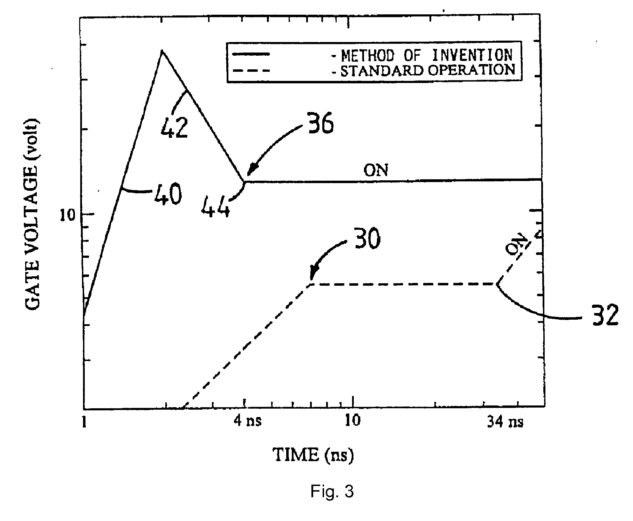

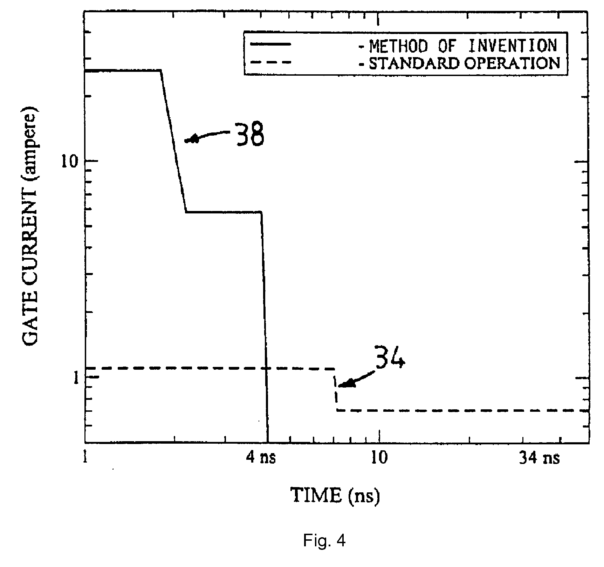

Time diagrams for the circuit in figure 1 are shown in figures 3 and 4. The diagrams in broken lines indicate normal specified operation of the MOSFET 12. Hence, diagram 30 in figure 3 shows the gate voltage of the MOSFET during conventional switching on. The MOSFET is switched on at 32 and the diagram illustrates a turn-on delay time of about 34ns. The associated gate current is shown at 34 in figure 4.

The diagrams for the method according to the invention are shown at 36 and 38 in figures 3 and 4 respectively. At 40 in figure 3, the aforementioned rapid transfer of charge from capacitor 14 through switch 16 and consequent build up of voltage on the gate of the MOSFET are shown. The subsequent fall in the gate voltage shown at 42 is attributable to the aforementioned Miller effect. What is clear though is that the device switches on at 44, after a mere 4ns. The associated current at the gate 20 is shown at 38 in figure 4. Initially, during the charge transfer stage, the gate current is high and thereafter it drops to a negligible level. It is also believed that with drain currents within the data specification of the MOSFET, switching losses with the switching method and circuit according to the invention are also reduced.

The value (C) of the capacitor 14, the voltage (V_{C}) required on the capacitor before switching and hence the breakthrough voltage of the switching device 16, the gate threshold voltage (Vₜ) of the MOSFET 12 and the gate charge (Q_{S}) required for complete switching of the MOSFET are related according to the following equation (C Vc)/(Qs/Vt + C) > Vt.

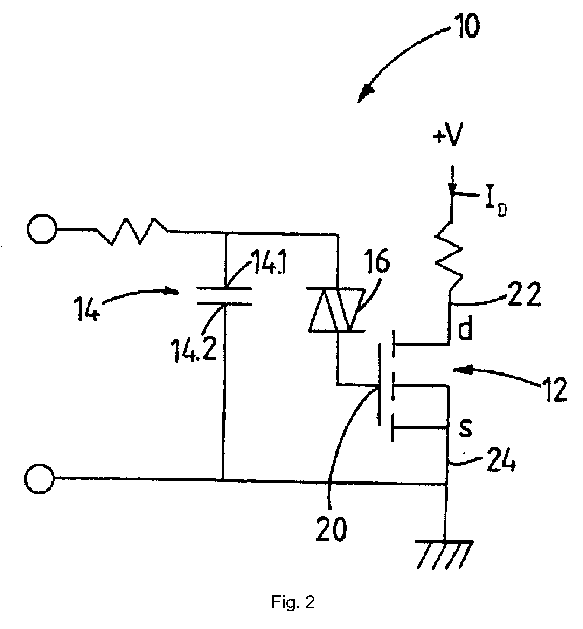

In figure 2 a circuit diagram of the triggering circuit 10 is shown wherein the first switching device 16 is a SIDAC.

A periodic voltage is applied across a capacitor 14, in parallel with a SIDAC 16 and a MOSFET 12. Initially, during a first half cycle, the voltage supplied at the input 19 is insufficient to switch the SIDAC 14 on and the capacitor 12 is hence charged up. When the supplied voltage reaches the threshold of the SIDAC 16 it switches on, resulting in a closed circuit from the capacitor 14 to the gate 20 of the MOSFET 12, partially discharging the capacitor 14 and hence charging the gate 20. The result is that a charge will now be shared between the capacitor 14 and the gate 20, so that some voltage, preferably above the gate threshold voltage relative to ground, is applied to the gate.

Using this method, the gate voltage may for short intervals be driven approximately three to four times beyond the maximum threshold rating of some MOSFET's 12 without destroying the device.

Similarly, when during the other half cycle the gate voltage exceeds the reverse threshold of the SIDAC 16 and current is conducted in the opposite direction, the gate voltage of the MOSFET 12 drops to substantially below the threshold voltage of the MOSFET 12 shortly after the charge dissipates from the gate 20 of the MOSFET 12. As a result, the MOSFET 12 will turn off and the drain current will no longer flow.

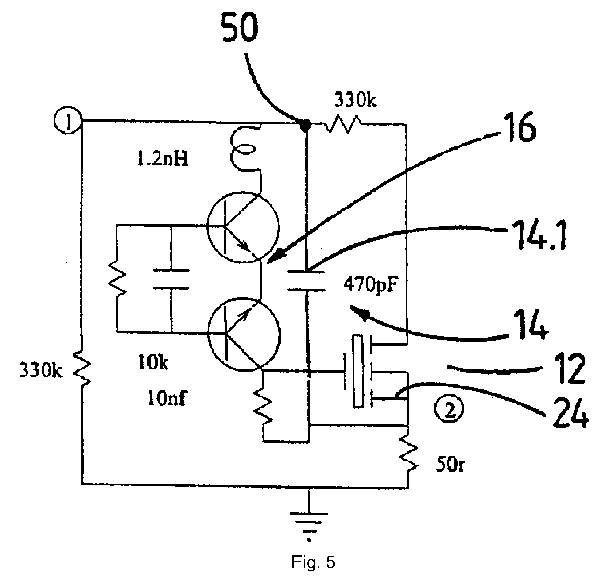

In figure 5, an alternative and self-oscillating triggering circuit for the MOSFET 12 is shown. Components thereof corresponding to components of the circuits in figures 1 and 2 are designated utilizing like reference numerals. In this embodiment, the fast switching means 16 comprises a bipolar transistor arrangement.

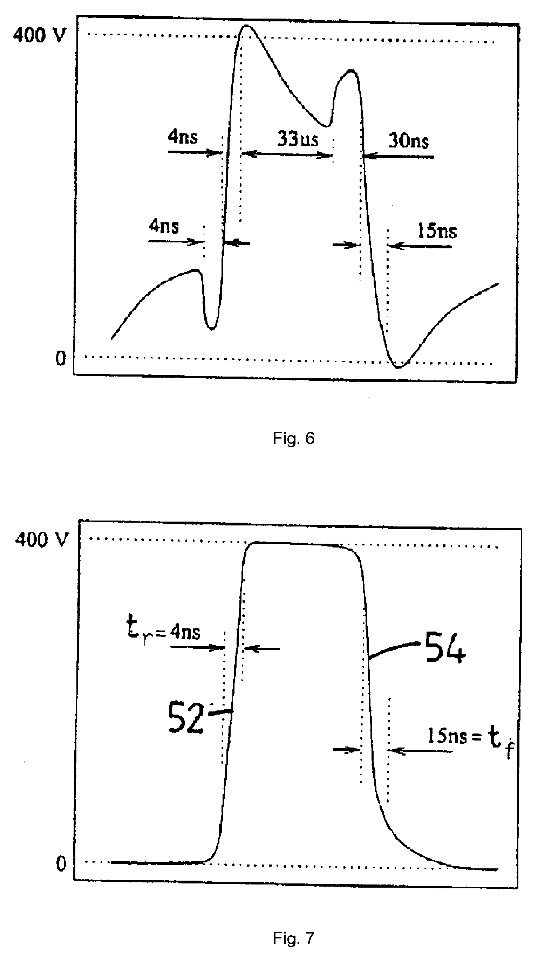

The voltage waveform at 50 is shown in figure 6. The voltage waveform at source 24 is shown in figure 7. From the latter waveform it can be seen at 52 that the source 24 of the aforementioned MOSFET 12 switches between an "off"-state to an "on"-state through about 400V in a rise time tᵣ of about 4ns, which is substantially quicker than the specified rise time of 27ns. Similarly, and as shown at 54 it switches from the "on"-state to the "off"-state in a fall time t_{f} of about 15ns, which is also substantially shorter than a specified fall time of about 24ns.

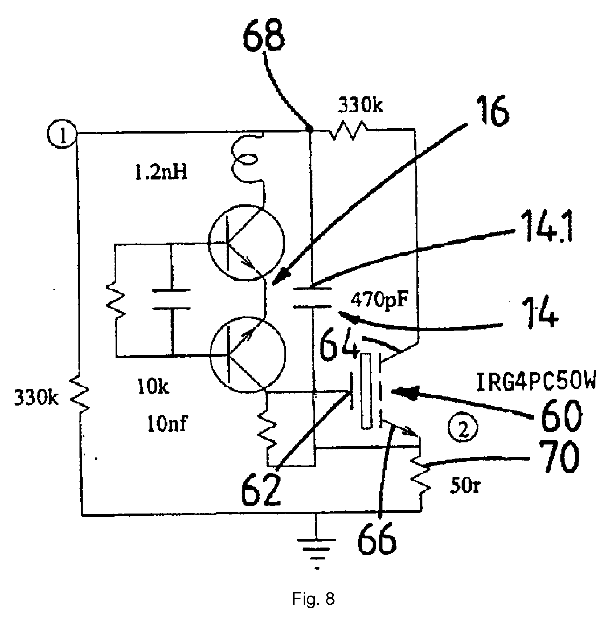

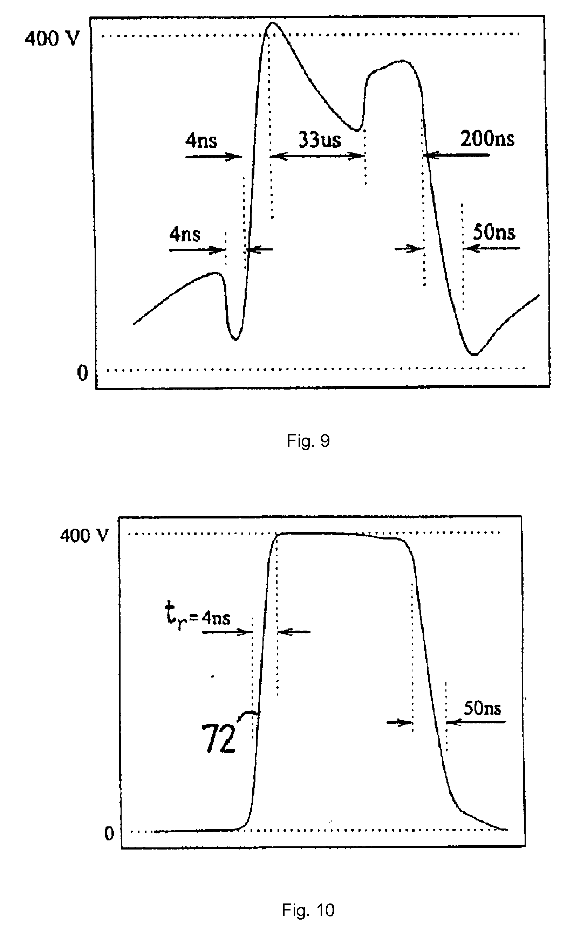

In figure 8, the same triggering circuit 10 is shown for an insulated gate bipolar transistor 60 having a gate 62, a collector 64 and an emitter 66. The transistor is an IRG4PC50W device which is being manufactured and sold by International Rectifier. The waveform at 68 in figure 8 is shown in figure 9 and the waveform at emitter 66 adjacent load 70 is shown in figure 10.

From the latter waveform it can be seen at 72 that the emitter 66 switches between an "off"-state and an "on"-state through about 400V in a rise time tᵣ of about 4ns, which is substantially less than a specified rise time of 33ns.

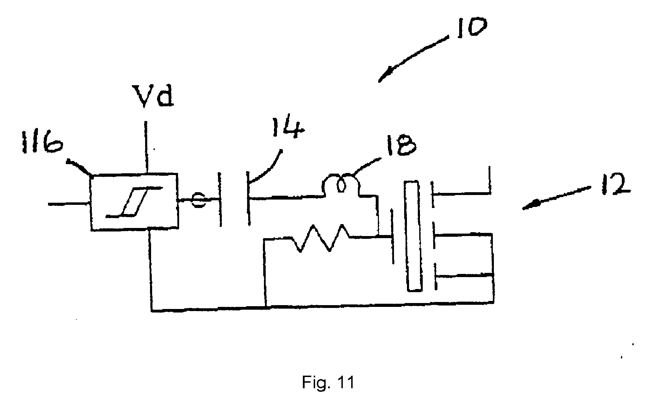

In figure 11 a further embodiment of the triggering circuit is shown. The switching means comprises a low output impedance, high voltage, fast switching driving circuit 116. The device 116 must be able to switch between OV and Vd in a first time period shorter than a specified turn-on delay time of the device 12. Vd is preferably bigger than 20xVt. Devices of this nature are available on the market.

It will be appreciated that there are many variations in detail on the triggering circuit and method according to the invention, without departing from the scope and spirit of the appended claims.

The invention also relates to:
A. A triggering circuit for an insulated gate semiconductor device comprising as a first terminal a gate and further comprising at least a second and a third terminal, the circuit comprising: - a charge storage device and a fast switching means connected in a circuit to the gate of the device; - the fast switching means being able to switch between an off and an on state in a first time period shorter than a specified turn-on delay time of the insulated gate device; and - the fast switching means being controllable to move charge between the storage device and the gate of the insulated gate device, so that the insulated gate device switches between an off state and an on state in a second time period shorter than a specified rise time or fall time for the insulated gate device.
B. A triggering circuit as defined in paragraph A wherein the insulated gate semiconductor device is a metal oxide semiconductor field effect transistor (MOSFET).
C. A triggering circuit as defined in paragraph B wherein the MOSFET is a power MOSFET.
D. A triggering circuit as defined in paragraph A wherein the insulated gate semiconductor device is an insulated gate bipolar transistor.
E. A triggering circuit as defined in any one of the paragraphs A to D wherein the first time period is shorter than 2ns.
F. A triggering circuit as defined in any one of paragraphs A to E wherein the fast switching means comprises one of: a SIDAC, a break-over diode, a bipolar transistor, another insulated gate semiconductor device and a high voltage fast switching device.
G. A triggering circuit as defined in any one of paragraphs A to F wherein the specified turn-on time is a minimum turn-on time specified in a data sheet relating to the insulated gate semiconductor device.
H. A triggering circuit as defined in any one of paragraphs A to G wherein the fast switching means is electronically controllable.
I. A triggering circuit as defined in any one of the paragraphs A to H wherein the charge storage device is a capacitor.
J. A triggering circuit as defined in any of the paragraphs A to I wherein the insulated gate semiconductor device switches from the off state to the on state as well as from the on state to the off state in periods shorter than specified rise and fall times respectively.
K. A triggering circuit as defined in any one of paragraphs A to J comprising an inductor between the fast switching means and the gate.
L. A triggering circuit as defined in any one of paragraphs A to K which is integrated on a single chip.
M. A triggering circuit as defined in paragraph L wherein the chip comprises additional circuitry also integrated thereon.
N. A method of driving an insulated gate semiconductor device comprising the steps of: - utilizing a fast switching means to transfer charge to or from a gate of the device; - switching the fast switching means on in a first time period shorter than a specified turn-on delay time of the insulated gate device; - moving charge to or from the gate to cause the insulated gate device to switch between an off and an on state in a second time period shorter than a specified rise time or fall time for the insulated gate device.

## Claims

1. A method of using a circuit to drive an insulated gate semiconductor device (12) comprising as a first terminal a gate (20) and at least second and third terminals (22, 24), the circuit comprising a charge storage device (14) and switching means (16, 116) connected in a series circuit to the gate of the semiconductor device to transfer charge from the charge storage device to the gate of the semiconductor device so as to switch the semiconductor device between one of an on state and an off state and the other of the on state and the off state, **characterised in that** sufficient charge to switch the device on is transferred from the charge storage device to the gate during a charge transfer stage which is complete prior to a change in the current flow between the second and third terminals (22, 24) of the semiconductor device.

2. A method according to claim 1, **characterised in that** the insulated gate semiconductor device (12) is a metal oxide semiconductor field effect transistor.

3. A method according to claim 2, **characterised in that** the metal oxide semiconductor field effect transistor is a power metal oxide semiconductor field effect transistor.

4. A method according to claim 1, **characterised in that** the insulated gate semiconductor device (12) is an insulated gate bipolar transistor.

5. A method according to any preceding claim, **characterised in that** the charge transfer raises the gate voltage of the insulated gate semiconductor device (12) three to four times beyond a maximum rating of the semiconductor device.

6. A method according to any preceding claim, **characterised in that** the switching means (16) is connected between the charge storage device (14) and the gate (20) of the semiconductor device (12).

7. A method according to any preceding claim, **characterised in that** a periodic voltage is applied across a capacitor forming the charge storage device (14), in parallel with a series connection of a SIDAC forming the switching means (16) and the gate-source path of a MOSFET forming the semiconductor device (12).

8. A method according to any preceding claim, **characterised in that** the switching means (16) is a SIDAC.

9. A method according to any one of claims 1 to 8, **characterised in that** the switching means (16) is selected from a break-over diode, a bipolar transistor, a further insulated gate semiconductor device and a high voltage fast switching device (116).

10. A method according to any preceding claim, **characterised in that** electronic control means is provided for the switching means (16).

11. A method according to any preceding claim, **characterised in that** the charge storage device (14) comprises a capacitor.

12. A method according to any preceding claim, **characterised in that** an inductor (18) is provided between the switching means (16, 116) and the gate (20).

13. A method according to any one of claims 1 to 11, wherein an inductor (18) is connected in series with the switching means (16, 116).

14. A method according to any preceding claim, **characterised in that** the circuit is integrated on a single chip.

15. A circuit for driving an insulated gate semiconductor device (12) comprising as a first terminal a gate (20) and at least second and third terminals (22, 24), the circuit comprising a charge storage device (14) and switching means (16, 116) connected in a series circuit to the gate of the semiconductor device to transfer charge from the charge storage device to the gate of the semiconductor device so as to switch the semiconductor device between one of an on state and an off state and the other of the on state and the off state, **characterised in that** the circuit is adapted such that sufficient charge to switch the device on is transferred from the charge storage device to the gate during a charge transfer phase which is complete prior to a change in the current flow between the second and third terminals (22, 24) of the semiconductor device and during which a voltage on the gate exceeds and then remains above a threshold voltage between the gate and the third terminal of the device.
